# EUROPEAN PATENT APPLICATION

(11) **EP 4 636 483 A2**
(43) Date of publication of application: **22.10.2025**
(21) Application number: 25197649.4
(22) Date of filing: 22.08.2025
(51) Int. Cl.: G03F 7/00

(54) **SUCTION CLAMP FOR CLAMPING A SUBSTRATE**

(71) Applicant: ASML Netherlands B.V., 5500 AH Veldhoven (NL)
(72) Inventor: DE GROOT, Antonius, Franciscus, Johannes, 5500 AH Veldhoven (NL)
(74) Representative: ASML Netherlands B.V.

(57) **Abstract**

A suction clamp for clamping a substrate, the suction clamp comprising a base; a substrate support extending perpendicular from the base in a first direction, the substrate support having a support area for supporting the substrate during clamping thereof; a resilient skirt member for receiving the substrate, wherein the skirt member extends around the substrate support; a fixing arrangement for removably fixing the skirt member to the base in an airtight manner; a suction opening arranged in the base and within a contour of the skirt member, the suction opening being adapted to be connected to a suction device for providing a suction force for clamping the substrate on the skirt member and the substrate support.

## Description

### FIELD

The present invention relates to a suction clamp for clamping a substrate and to a method for performing maintenance on a suction clamp. The present invention further relates to an end-effector for an object handler, the end-effector comprising a suction clamp. The present invention yet further relates to an exposure apparatus comprising a suction clamp.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

While the pattern is being projected on the substrate, the substrate is typically mounted on a substrate support. To arrange the substrate on the substrate support a plurality of support members are arranged to receive the substrate. The support members may comprise one or more suction clamps for clamping the substrate using a clamping force. After receiving the substrate, the support members are simultaneously moved vertically downwards until the substrate is supported by the substrate support.

Typically, the substrate is arranged onto said support members by an object gripper. The gripper may also comprise one or more suction clamps for clamping the substrate using a clamping force.

Developments in recent years have led to substrates having an out-of-plane shape, e.g., being warped or bent as opposed to being completely flat. This may e.g., be a consequence of an increasing number of layers which have internal stresses. It has been observed that such warped or bent substrates are not always clamped properly by the conventional suction clamps of an object handler.

Warped substrates can also negatively affect the lifetime of the suction clamps. Certain parts of a substrate support surface of the suction clamp may experience more wear and tear than other parts of the substrate support surface of the suction clamp. If the substrate is slightly bended, part of the substrate may slide across a part of the substrate support surface of the suction clamp during a clamping phase. This sliding induces local wear on the suction clamp, which local wear then dicates the lifetime of the suction clamp. A shorter lifetime of the suction clamp results in a higher maintenance frequency. More maintenance in turn results in more idle time of the exposure apparatus. Idle time is to be avoided or reduced as much as possible.

### SUMMARY

It is an object of the invention to at least partially mitigate the aforementioned disadvantages.

According to an embodiment of the invention, there is provided a suction clamp for clamping a substrate, the suction clamp comprising:
- a base,
- a substrate support extending perpendicular from the base in a first direction, the substrate support having a support area for supporting the substrate during clamping thereof,
- a resilient skirt member for receiving the substrate, wherein the skirt member extends around the substrate support,
- a fixing arrangement for removably fixing the skirt member to the in an airtight manner,
- a suction opening arranged in the base and within a contour of the skirt member, the suction opening being adapted to be connected to a suction device for providing a suction force for clamping the substrate on the skirt member and the substrate support.

According to a further embodiment of the invention, there is provided an end-effector for an object handler, the end-effector comprising a suction clamp according to the invention.

According to a further embodiment of the invention, there is provided an exposure apparatus comprising a suction clamp according to the invention.

According to a further embodiment of the invention, there is provided a method for performing maintenance on a suction clamp, comprising:
- providing a suction clamp according to the invention,
- removing the resilient skirt member via the fixing arrangement,
- placing a new resilient skirt member around the support member and removably fixing the skirt member to the base via the fixing arrangement.

### BRIEF DESCRIPTION OF THE DRAWINGS

Embodiments of the invention will now be described, by way of example only, with reference to the accompanying schematic drawings, in which:
- Figure 1 depicts a schematic overview of an exposure apparatus according to an embodiment of the invention;
- Figure 2 depicts a detailed view of a part of the exposure apparatus of Figure 1;
- Figure 3A shows a side view of a stage apparatus which comprises an object support;
- Figure 3B schematically shows an object handler in a plan view;
- Figure 4 schematically shows in plan view an embodiment of an end-effector according to the invention comprising a plurality of suction clamps, wherein a substrate is clamped by the suction clamps.
- Figures 5 to 11 schematically show in cross-section different embodiments of a suction clamp according to the invention.
- Figures 12 to 14 schematically show in cross-section, and in plan view, different embodiments of a fixing arrangement.
- Figures 15 to 17 schematically show in cross-section different embodiments of a resilient skirt member.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

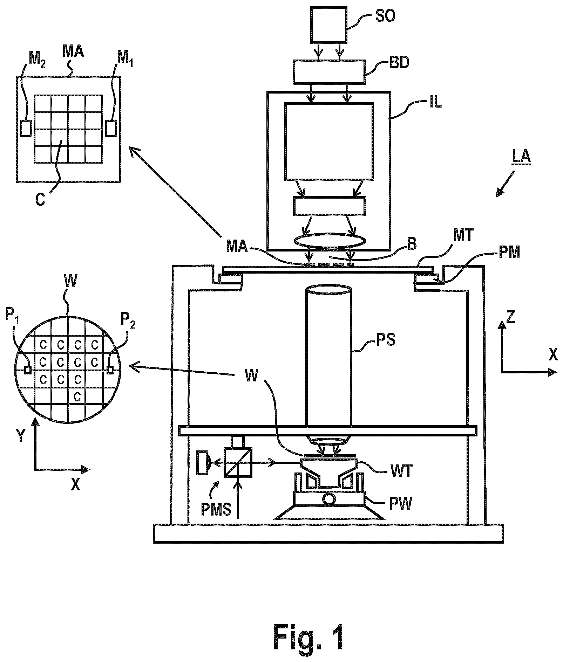

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such a "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

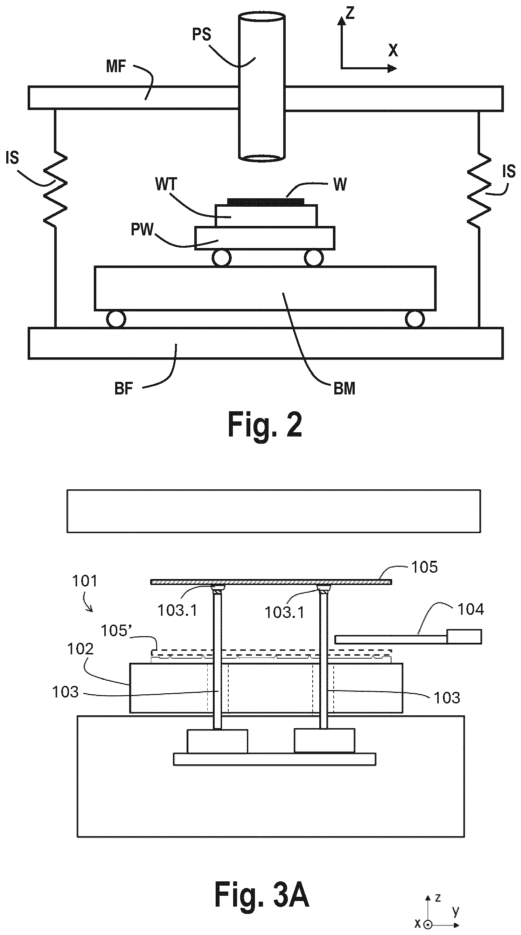

Figure 2 shows a more detailed view of a part of the lithographic apparatus LA of Figure 1. The lithographic apparatus LA may be provided with a base frame BF, a balance mass BM, a metrology frame MF and a vibration isolation system IS. The metrology frame MF supports the projection system PS. Additionally, the metrology frame MF may support a part of the position measurement system PMS. The metrology frame MF is supported by the base frame BF via the vibration isolation system IS. The vibration isolation system IS is arranged to prevent or reduce vibrations from propagating from the base frame BF to the metrology frame MF.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor, a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.

Figure 3A shows a side view of a stage apparatus 101 which comprises an object support 102 configured to support an object 105, which e.g., is a substrate W or a wafer. The object support 102 may e.g., be supported by another support as shown in Figure 3a. The stage apparatus 101 e.g., comprises a plurality of support members 103 for supporting the object 105, arranged to receive the object 105 from an end-effector 104 and to arrange the object 105 on the object support 102 and/or vice versa. The support members 103 are moveable in at least a vertical direction z which is perpendicular to a first plane xy. In the shown embodiment, the stage apparatus 101 comprises three support members 103 of which two are visible in the side view shown in Figure 3A. The three support members 103 are preferably arranged such that when seen in top view an imaginary equilateral triangle can be drawn wherein the support members 103 are situated on the corners. It is noted however that any suitable number of support members 103 may be applied in any suitable arrangement.

Loading the object 105, i.e. arranging the object 105 on the object support 102, can then e.g., be accomplished as follows. In the situation shown in Figure 3A the object 105 is supported by the support members 103 and an end-effector 104 has been partially retracted. Prior to this situation the object 105 was supported by the end-effector 104, which arranged the object 105 above the object support 102 to provide the object 105 to the stage apparatus 101. The end-effector 104 may e.g., be driven by a robot, e.g., a multi-axis robot arm, which is part of an object handler that provides the object 105. The support members 103 are then moved vertically upwards from a retracted position wherein they are arranged below the object support 102 to a supporting position shown in Figure 3A. During said vertically upwards movement the support members 103 engage the object 105. Once the object 105 is supported by the support members 103 the gripper 104 can be retracted to correspond with the situation shown in Figure 3A. When the gripper 104 is retracted in a horizontal direction, the support members 103 are then moved vertically downwards until the object 105 is arranged on the object support 102, as indicated by the dashed lines 105'.

The object 105 can be unloaded in a similar manner, e.g.. after the pattern has been projected on the object 105. While the object 105 is arranged on the object support 102, the support members 103 are in the retracted position below a top surface of the object support 102. The support members 103 can be moved vertically upwards in the vertical direction z until they engage the object 105, such that the object 105 is supported by the support members 103 instead of the object support 102. The support members 103 can then be further moved vertically upwards in the vertical direction z until they reach the supporting position as shown in Figure 3a again. The end-effector 104 can then be moved below the object 105 to support the object 105. For example, the end-effector 104 can be moved vertically upwards after being arranged under the object 105 in order the engage the object. It is also possible to move the support members 103 vertically downwards after the end-effector 104 has been arranged below the object 105 until the end-effector 104 engages the object 105. Alternatively end-effector 104 can be moved above the object 105. For example, the end-effector 104 can be moved vertically downwards after being arranged above the object 105 in order the engage the object. It is noted that in an embodiment the end-effector used for unloading of the object 105 may be an end-effector which is different from the end-effector 104 used for providing the object 105, e.g., both grippers may be arranged on opposite sides of the object 105, e.g., on the left and right side in Figure 3A.

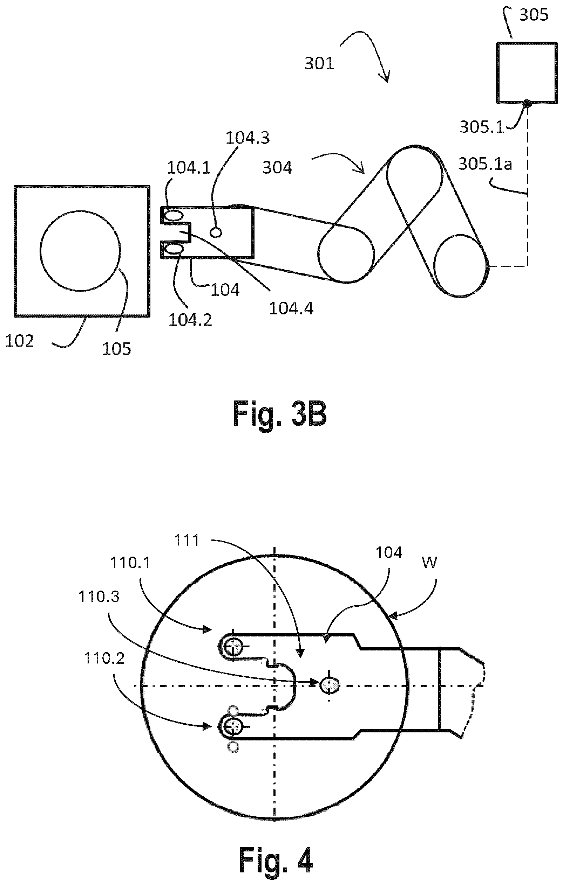

Figure 3B schematically shows an object handler 301 in a top view. It is noted that for the sake of clarity Figure 3B does not depict all components, but focuses on those relevant for the explanation that follows. The object handler 301 comprises a robot arm 304, configured to provide the object 105 to the object support 102, and a control unit 305. Figure 3B further shows that the control unit 305 has a first output terminal 305.1 for controlling the robot arm 304 with a first control signal 305.1a. The robot arm 304 comprises the end-effector 104, and the position of the end-effector 104 can thus be controlled as such. Since the end-effector 104 arranges the object 105 above the object support 102 for the support members to engage the object 105, the position of the object 105 relative to the object support 102 can be controlled as such. The robot arm 304 may further be able to repeat its movement repetitively with high precision, such that each object 105 can be arranged on substantially the same position relative to the object support 102 .

Figure 3A further shows that the support members 103 comprise suction clamps 103.1, and Figure 3B shows that the end-effector 104 in the shown embodiment comprises suctions clamps 110 for clamping a substrate, in particular a first suction clamp 110.1, a second suction clamp 110.2, and a third suction clamp 110.3. The end-effector 104 generally has two, three or four suction clamps 110. Figure 4 schematically shows in top view the end-effector 104 clamping a substrate W via the three suction clamps 110.1, 110.2, 110.3.

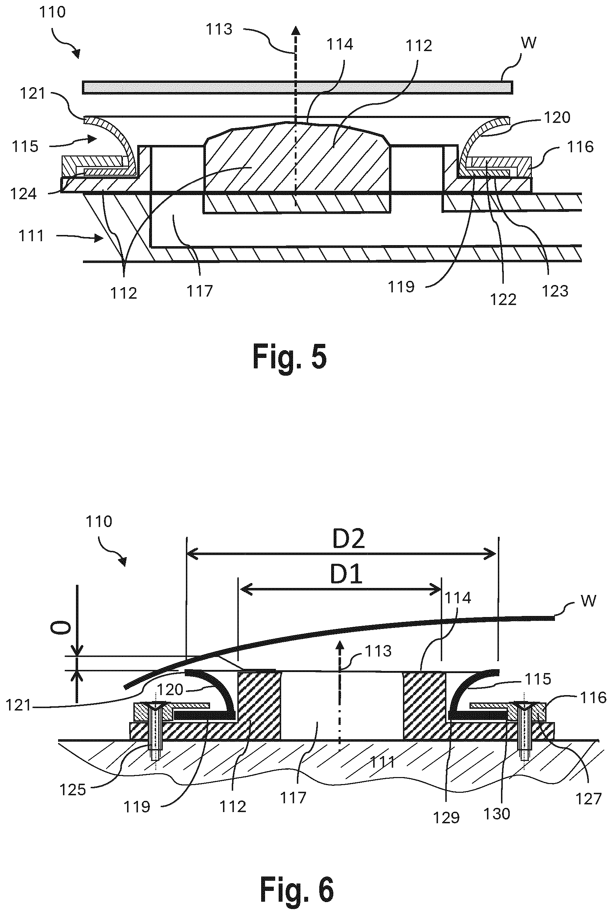

Exemplary embodiments of a suction clamp 110 for clamping a substrate are shown in the cross-sectional views of Figures 5 to 11.

The suction clamp 110 for clamping a substrate comprises a base 111, a substrate support 112, a resilient skirt member 115, a fixing arrangement 116, and a suction opening 117.

The substrate support 112 extends perpendicular from the base 111 in a first direction 113. The first direction 113 is parallel to the Z-axis as shown in Figure 3A and projects normal to the base 111. The substrate support 112 has a support area 114 for supporting the substrate during clamping thereof. The base 111 and the substrate support 112 may be integrally connected.

The support area 114, or substrate contacting surface, may be straight or represent a rounded contour, or may be a combination of straight and rounded. A rounded contour may reduce an area of the substrate on which it is supported. The support area 114 may be non-resilient, or rigid. This also may reduce the area of the substrate on which it is supported, compared to a resilient support area 114. A reduced support area can result in less damage to the substrate, because less contact surface means a smaller area of contact for transfer of contaminations from the support area to the substrate, and less wear. A reduced support area can also help when handling warped substrates, because the smaller the contact area, the less influence the warpage has on the efficacy of the suction clamp.

The resilient skirt member 115 receives the substrate W. The skirt member 115 extends around the substrate support 112. The skirt member 115 may extend to a plane beyond that of the support area 114 in the first direction 113, see for example Figure 5. The skirt member 115 may extend to a plane that is located lower than or is flush with that of the support area 114, see for example Figure 6 showing a free end 121 of the skirt located in the same plane as the support area 114. In the example of Figure 6, the skirt member thus extends to a plane that is flush with that of the support area. A first diameter D1 of the support area is smaller than a second diameter D2 of the skirt member at the free end 121 thereof, see Figure 6. The difference in diameters results in a larger vacuum area, which increases the suction force on the substrate, thereby increasing the clamping force. The skirt member 115 can be made of for example a rubber, polyurethane, nitrile rubber Viton, EPDM, silicone, FKM, or Neoprene.

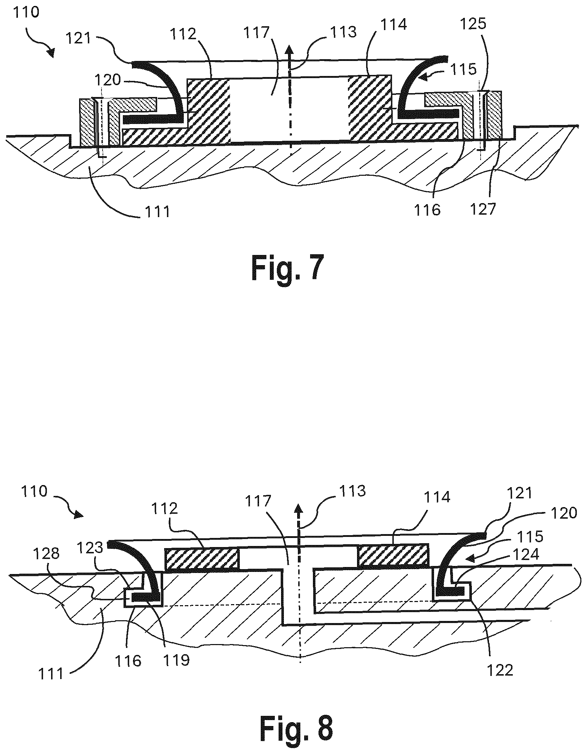

The fixing arrangement 116 is configured to removably fix the skirt member 115 to the base 111 in an airtight manner. The skirt member 115 can be fixed directly to the base 111, see for example Figure 8. The skirt member 115 can also be fixed indirectly to the base 111, e.g. via the substrate support 112, see for example Figures 5 and 6. In the examples of Figures 5 and 6 part of the substrate support 112 extends under a flange part 119 of the skirt member. While the resilient skirt member 115 may improve the clamping of warped substrates W, the resilient skirt member 115 is prone to wear and tear. It may be the part of the suction clamp that is most prone to wear and tear. With a fixing arrangement that removably fixes the skirt member 115 to the base, the part that is prone to wear and tear, i.e., the skirt member 115, can be easily removed and replaced by a new resilient skirt member 115. Maintenance therefore becomes more straightforward without any requirement to replace all the parts of the suction clamp 110. With the fixing arrangement the idle time of the exposure apparatus can be reduced.

A suction opening 117 is arranged in the base 111 and within a contour of the skirt member 115, when seen from the first direction 113. The suction opening 117 is adapted to be connected to a suction device for providing a suction force for clamping the substrate on the skirt member 115 and the substrate support 112. When the free end 121 of the resilient skirt member 115 touches the substrate in use, a vacuum force is built up that pulls the substrate towards or against the support area 114 of the support member. The resilience, or flexibility, of the skirt member 115 can improve the clamping of warped substrates. Warped substrates are substrates that are not completely straight. A completely straight substrate W is schematically shown in Figure 5. A warped substrate W is schematically shown in Figure 6.

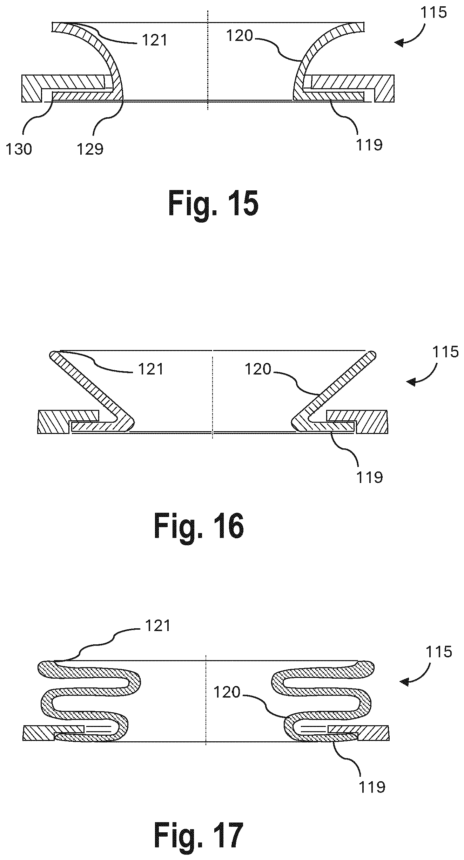

The skirt member 115 comprises a flange part 119 for removably fixing the skirt member 115 to the base 111, i.e. directly or indirectly, via the fixing arrangement 116. The flange part 119 extends substantially perpendicular to the first direction 113. The skirt member 115 comprises a wall part 120 that extends in the first direction 113 from a plane of the flange part 119 to a plane of the support area 114. The wall part 120 has a free end 121 for engaging the substrate. The wall part 120 may have different shapes, see for example figures 15 to 17. In top view, i.e. seen from the first direction 113, the wall part 120 may also present different shapes, e.g., circular, oval, square, rectangular, polygonial or any other appropriate shape.

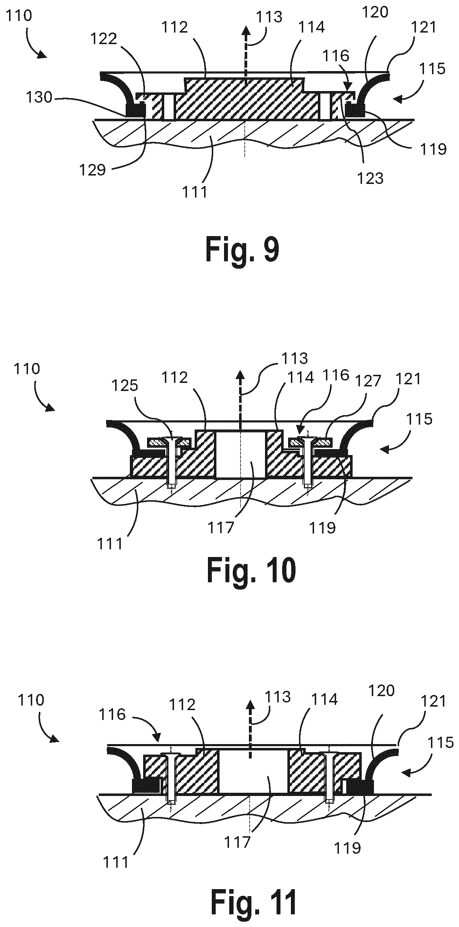

The flange part 119 has an inner circumference 129 and an outer circumference 130, see e.g. figures 6, 9 and 15. The wall part 120 may be connected to the flange part 119 at the inner circumference 129 thereof, see for example figures 5 to 8, or at the outer circumference 130 thereof, see for example figures 9 to 11.

The fixing arrangement 116 comprises a flange fixing part 122 configured to fix the flange part 119 of the skirt member 115 relative to the base 111.

The flange fixing part 122 comprises an engaging surface 123 for engaging an upper surface 124 of the flange part 119. The upper surface 124 may face at least a portion of the wall part 120 of the skirt member 115. The engaging surface 123 extends in a direction substantially perpendicular to the first direction 113.

The fixing arrangement 116 may comprise one or more fastening members 125 for providing a connection between the skirt member 115 and the base 111, see for example Figures 6, 10, 11, 13, 14. The fastening members 125 may for example comprise bolts, which allow for a quick and easy replacement of the skirt member 115 while providing a strong and air tight connection. The person skilled in the art will recognise that any suitable fastening member may be used.

The fixing arrangement 116 may comprise a separable fixing unit 127, see for example figures 6, 7, 10. The separable fixing unit 127 removably fixes the skirt member 115 to the base 111 via the connection. The fixing unit 127 comprises the engaging surface 123. The fixing unit 127 engages the upper surface 124 of the flange part 119 for clamping the flange part 119 between the fixing unit 127 and the base 111 and/or between the fixing unit 127 and the support member.

In Figures 6 and 7 the fixing unit 127 has an L-shaped cross-section, wherein one leg of the L extends perpendicular to the first direction 113, said one leg of the L comprising the engaging surface 123. The other leg of the L extends parallel to the first direction 113 and is connected to the base 111 via fastening members 125. In Figure 10 the separable fixing unit 127 is a flat body fastened to the base 111 via fastening members 125. The one or more fastening members 125 extend into the substrate support 112 and/or into the base 111. In an embodiment, the separable fixing unit 127 may, when viewed from above, i.e., when viewed from the first direction, have the shape of an annular ring. For example, said annular ring may comprise the shape of a circle, oval, square, rectangle, polygon or any other appropriate shape.

Figure 8 shows an example, wherein the flange fixing part 122 is provided as a cavity 128 extending into the base 111. The cavity 128 has an L-shape when viewed in cross-section. The L-shape allows for a snap-fit of the flange part 119 of the skirt member 115 into the cavity 128. The angle between the two arms of the L-shape of the cavity may be substantially 90°, alternatively the angle between the two arms of the L-shape may be substantially less than 90°, for example in the range of 45-90°, or smaller. Alternatively the angle between the two arms of the L-shape may be substantially more than 90°, for example in the range 90-135°, or larger. Advantageously, the choice of angle may facilitate the fitting and removal of the flange part 119 of the skirt member 115 into the cavity 128. Providing the flange fixing part 122 as a cavity 128 can reduce the amount of parts and/or material needed for the fixing arrangement 116. Also, the cavity 128 can reduce the number of particles, that are released from the flange part 119, moving towards the substrate. That is because the fixing interface, in particular the flange of the skirt member 115, is not in direct contact or visual sight with the substrate. The released particles can negatively affect the substrate.

Turning to Figures 9 to 11, different fixing arrangements are shown. Figures 9 and 11 show examples of the fixing arrangement 116 being integrated with the substrate support 112. Here the engaging surface 123 extends outwardly from the substrate support 112. In Figure 9 the substrate support 112 is also integrated with the base 111. In Figure 11 the substrate support 112 is connected to the base 111 via at least one fastening member. Figure 10 shows an example wherein a separable fixing unit is connected to the base 111 via at least one fastening member, thereby clamping the flange part 119 of the skirt member 115.

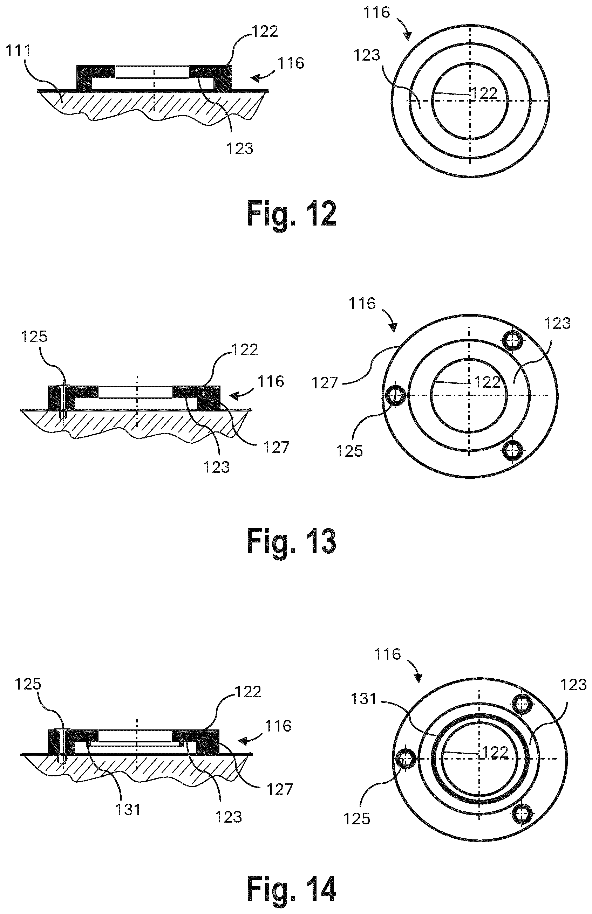

Figure 12 shows a cross-section (left) of an example of a fixing arrangement 116 being glued to the base 111. An underside view of the fixing arrangement 116 is also illustrated (right). Figure 13 shows in cross-section (left) an example of a fixing arrangement 116 comprising a separable fixing unit 127 being fastened to the base 111 via a fastening member 125. An underside view of the separable fixing unit 127 and example placement of fastening members 125 is also illustrated (right). Figure 14 shows in cross-section (left) an embodiment of a separable fixing unit 127, wherein a protrusion 131 extends from the engaging surface 123. An underside view of the separable fixing unit 127 with protrusion 131 extending from the engaging surface 123 is also illustrated (right). The protrusion 131 can increase the mechanical stress locally when the fixing unit 127 compresses the flange part 119 of the skirt member 115. The protrusion 131 may therefore provide a stronger fixation, or connection of the flange part. The skilled person will recognise that while the example of Figure 14 illustrates the use of a protrusion 131 as part of a separable fixing unit 127, said protrusion 131 may also be applies to a non-separable fixing arrangement 116.

The suction clamp 110 according to the invention allows for relatively easy and quick maintenance, thereby reducing valuable idle time of the exposure apparatus. When it is time to replace the resilient skirt member 115, usually due to wear, the resilient skirt member 115 can be removed via the fixing arrangement 116, e.g. via loosening the bolts in the examples of Figures 6, 7, 10, 11, 13 or via an impact force on the snap-fit as shown in the examples of Figures 8 and 9. After the resilient skirt member 115 is removed a new resilient skirt member 115 can be placed around the support member and removably fixed to the base 111 via the fixing arrangement 116.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below. Other aspects of the invention are set out as in the following numbered clauses:
1. A suction clamp for clamping a substrate, the suction clamp comprising:
   - a base,
   - a substrate support extending perpendicular from the base in a first direction, the substrate support having a support area for supporting the substrate during clamping thereof,
   - a resilient skirt member for receiving the substrate, wherein the skirt member extends around the substrate support,
   - a fixing arrangement for removably fixing the skirt member to the base in an airtight manner,
   - a suction opening arranged in the base and within a contour of the skirt member, the suction opening being adapted to be connected to a suction device for providing a suction force for clamping the substrate on the skirt member and the substrate support.
2. A suction clamp according to clause 1, wherein the skirt member comprises
   - a flange part for removably fixing the skirt member to the base via the fixing arrangement, the flange part extending perpendicular to the first direction,
   - a wall part extending in the first direction from the flange part, the wall part having a free end for engaging the substrate.
3. A suction clamp according to clause 2, wherein the fixing arrangement comprises a flange fixing part configured to fix the flange part of the skirt member relative to the base.
4. A suction clamp according to clause 3, wherein the flange fixing part comprises an engaging surface for engaging an upper surface of the flange part.
5. A suction clamp according to clause 4, wherein the engaging surface extends in a direction perpendicular to the first direction.
6. A suction clamp according to clause 4 or 5, wherein the engaging surface extends outwardly from the substrate support.
7. A suction clamp according to any one of the preceding clauses, wherein the fixing arrangement comprises one or more fastening members for providing a connection between the skirt member and the base.
8. A suction clamp according to clause 7, wherein the fixing arrangement comprises a separable fixing unit, wherein the separable fixing unit removably fixes the skirt member to the base via the connection.
9. A suction clamp according to clause 8, wherein the separable fixing unit comprises the engaging surface, and wherein the separable fixing unit engages the upper surface of the flange part for clamping the flange part between the fixing unit and the base.
10. A suction clamp according to any one of clauses 7-9, wherein the one or more fastening members extend into the substrate support and/or into the base.
11. A suction clamp according to any one of clauses 3-10, wherein the flange fixing part is provided as a cavity extending into the base.
12. A suction clamp according to any one of the preceding clauses, wherein the base and the substrate support are integrally connected.
13. A suction clamp according to any one of clauses 2-12, wherein the flange part has an inner circumference and an outer circumference, wherein the wall part is connected to the flange part at the inner circumference and/or at the outer circumference.
14. A suction clamp according to any one of the preceding clauses, wherein the support area is convex.
15. A suction clamp according to any one of the preceding clauses, wherein the support area is non-resilient.
16. A suction clamp according to any one of the preceding clauses, wherein the skirt extends beyond the support area in the first direction.
17. A suction clamp according to any one of the preceding clauses, wherein a substrate-contacting surface of the substrate support presents a rounded contour.
18. An end-effector for an object handler, the end-effector comprising a suction clamp according to any one of the preceding clauses.
19. An exposure apparatus comprising a suction clamp according to any one of clauses 1-17.
20. A method for performing maintenance on a suction clamp, comprising:
   a. providing a suction clamp according to any one of clauses 1-17,
   b. removing the resilient skirt member via the fixing arrangement,
   c. placing a new resilient skirt member around the support member and removably fixing the skirt member to the base via the fixing arrangement.

## Claims

1. A suction clamp for clamping a substrate, the suction clamp comprising:
- a base,
- a substrate support extending perpendicular from the base in a first direction, the substrate support having a support area for supporting the substrate during clamping thereof,
- a resilient skirt member for receiving the substrate, wherein the skirt member extends around the substrate support,
- a fixing arrangement for removably fixing the skirt member to the base in an airtight manner,
- a suction opening arranged in the base and within a contour of the skirt member, the suction opening being adapted to be connected to a suction device for providing a suction force for clamping the substrate on the skirt member and the substrate support.

2. A suction clamp according to claim 1, wherein the skirt member comprises
- a flange part for removably fixing the skirt member to the base via the fixing arrangement, the flange part extending perpendicular to the first direction,
- a wall part extending in the first direction from the flange part, the wall part having a free end for engaging the substrate.

3. A suction clamp according to claim 2, wherein the fixing arrangement comprises a flange fixing part configured to fix the flange part of the skirt member relative to the base.

4. A suction clamp according to claim 3, wherein the flange fixing part comprises an engaging surface for engaging an upper surface of the flange part.

5. A suction clamp according to claim 4, wherein the engaging surface extends in a direction perpendicular to the first direction.

6. A suction clamp according to claim 4 or 5, wherein the engaging surface extends outwardly from the substrate support.

7. A suction clamp according to any one of the preceding claims, wherein the fixing arrangement comprises one or more fastening members for providing a connection between the skirt member and the base.

8. A suction clamp according to claim 7, wherein the fixing arrangement comprises a separable fixing unit, wherein the separable fixing unit removably fixes the skirt member to the base via the connection.

9. A suction clamp according to any one of claims 3-8, wherein the flange fixing part is provided as a cavity extending into the base.

10. A suction clamp according to any one of the preceding claims, wherein the base and the substrate support are integrally connected.

11. A suction clamp according to any one of the preceding claims, wherein the support area is non-resilient.

12. A suction clamp according to any one of the preceding claims, wherein a substrate-contacting surface of the substrate support presents a rounded contour.

13. An end-effector for an object handler, the end-effector comprising a suction clamp according to any one of the preceding claims.

14. An exposure apparatus comprising a suction clamp according to any one of claims 1-12.

15. A method for performing maintenance on a suction clamp, comprising:
a. providing a suction clamp according to any one of claims 1-12,
b. removing the resilient skirt member via the fixing arrangement,
c. placing a new resilient skirt member around the support member and removably fixing the skirt member to the base via the fixing arrangement.
